# EUROPEAN PATENT APPLICATION

(11) **EP 3 489 702 A1**
(43) Date of publication of application: **29.05.2019**
(21) Application number: 18180764.5
(22) Date of filing: 29.06.2018
(51) Int. Cl.: G01R 31/371

(54) **BATTERY DETECTION SYSTEM**

(30) Priority: 28.11.2017 TW 106141287
(71) Applicant: Mashin Electric Corp., 721 Tainan City (TW)
(72) Inventor: KUO, TAI YOU, 721 Tainan City (TW); KAO, CHUAN YI, 721 Tainan City (TW)
(74) Representative: Cabinet Chaillot

(57) **Abstract**

Provided is a battery detection system, including a battery testing device, a mobile processing module and a mobile display module. The battery testing device includes a test processor, a memory module and a Bluetooth transmission module. The test processor tests a battery and collects data of the battery, and stores the data in the memory module. The mobile processing module is disposed in a mobile device and processes the data from the battery testing device through the Bluetooth transmission module. The mobile display module is disposed in the mobile device and shows the results processed by the mobile processing module.

## Description

### BACKGROUND OF THE INVENTION

### 1. Field of the Invention

The present disclosure relates to a battery detection system.

### 2. The Prior Arts

Nowadays, consumers generally think that the batteries that can be used to start motorbikes and automobile engines are all good or in good conditions. However, in fact, this is not the case. As long as the plates are 50% efficient, the automobile engines can be started. After the automobile engines are started, sine the power generated by the power generator is insufficient, engine jitter or acceleration sluggishness may be caused. It is difficult to predict when a battery will suddenly break down. Fortunately, battery testers can easily measure the battery life cycle.

Battery testers in the market can be divided into discharge type battery testers and internal resistance type battery testers. The discharge type battery testers have the following advantages and disadvantages. Advantages: 1. low cost and simple structure, and 2. long product life and not easy to damage; Disadvantage: 1. measurement of a battery is limited by the maximum current and the discharge type of battery testers are not easy to use, 2. repeated measurement error gradually increased, 3. a battery to be tested before charging, and 4. good and bad can only be judged by users.

Moreover, the internal resistance type battery testers have the following advantages and disadvantages. Advantages: 1. wide measurable range for batteries, 2. high consistency of repeated measurements, 3. Ease of use and measurement of batteries can be performed under any circumstances, and 4. effective analysis results. Disadvantages: 1. expensive, and 2. requiring to measure together with precision measurement and LCD and microprocessor to obtain results.

As such, how to provide a better battery tester that can provide end users an effective quantitative result of a battery has become one of important issues.

### SUMMARY OF THE INVENTION

It is a primary object of the present invention to provide a battery detection system.

In order to achieve the above objective, the present disclosure provides a battery detection system, including a battery testing device, including a test processor, a memory module and a wireless transmission module, wherein the test processor tests a battery and collects data of the battery, and stores the data in the memory module; a mobile processing module, disposed in a mobile device, and processes that data from the battery testing device through the wireless transmission module; a mobile display module, disposed in the mobile device, and displays a processing result; and a cloud database device, including a cloud database, a cloud database processing module, a result push module and a cloud website module, wherein the cloud database stores the data from the mobile device, the cloud database processing module automatically extracts and calculates/analyzes the data in the cloud database, and sends an operation result or historical test data to the cloud website module through the result push module.

Preferably, the mobile device further includes a module storage module, a wireless login module and a cloud database login module.

Preferably, the mobile storage module stores a plurality of user test history data.

Preferably, the wireless login module includes a username and a wireless device name, wherein the wireless login module is connected to the wireless transmission module by wireless transmission to read the data of the battery.

Preferably, the cloud database login module includes a username and a PIN code, wherein the cloud database login module is connected to the cloud website module by Internet transmission to read the operation result and the historical test data.

Preferably, the mobile processing module performs battery monitoring, battery testing, startup system testing and charging system testing on the battery.

Preferably, the data includes a battery voltage, a battery internal resistance and a starting current.

Preferably, the battery may be one of a lead-acid battery and a lithium battery.

Preferably, the wireless transmission module may be one of a 3G module, a 4G module, a wireless network module, an RFID module and a Bluetooth transmission module.

### BRIEF DESCRIPTION OF THE DRAWINGS

Fig. 1 shows a block diagram of a battery detection system according to a preferred embodiment of the present disclosure.
Fig. 2 shows a block diagram of a battery testing device of the battery detection system according to the preferred embodiment of the present disclosure.
Fig. 3 shows a block diagram of a mobile device of the battery detection system according to the preferred embodiment of the present disclosure.
Fig. 4 shows a block diagram of a cloud database device of the battery detection system according to the preferred embodiment of the present disclosure.

### DETAILED DESCRIPTION OF THE PREFERRED EMBODIMENT

The detailed description of the present invention is provided in combination with the accompanying drawings.

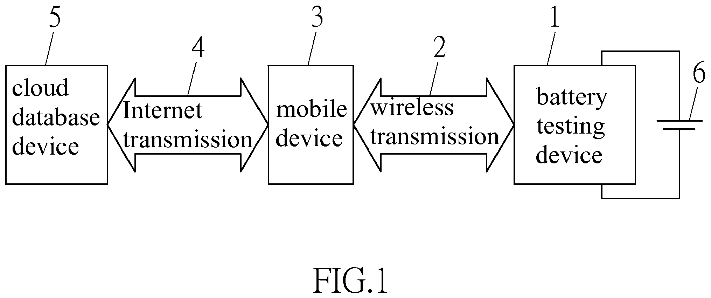

According to a preferred embodiment of the present disclosure, Fig. 1 shows a block diagram of a battery detection system. As shown in Fig. 1, the battery detection system of the present disclosure includes a battery testing device 1 and a mobile device 3.

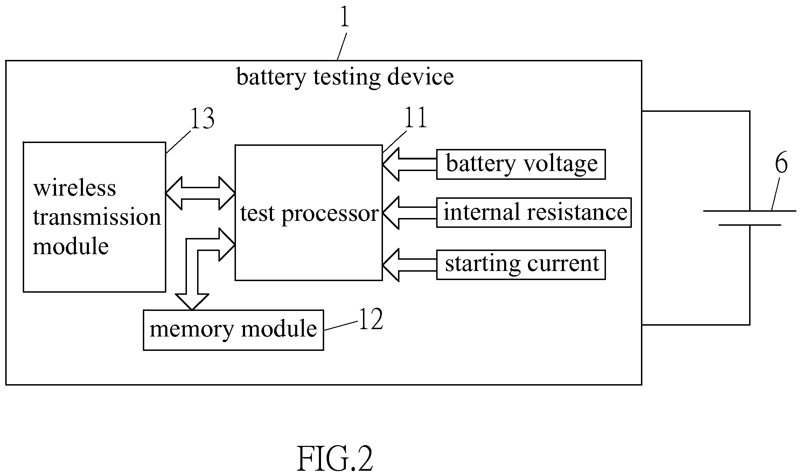

As shown in Fig. 2, the battery testing device 1 of the present disclosure includes a test processor 11, a memory module 12 and a wireless transmission module 13. The test processor 11 may test a battery 6 and collect data of the battery 6, and stores the data in the memory module 12.

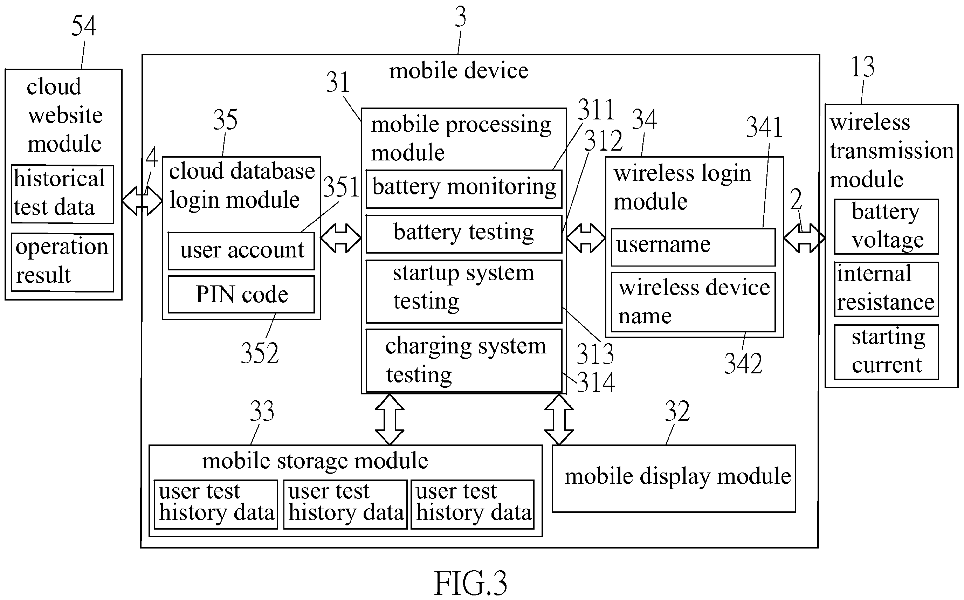

Moreover, as shown in Figs. 3, a mobile processing module 31 of the present disclosure is disposed in a mobile device 3, and processes the data from the battery testing device 1 through the wireless transmission module 13. A mobile display module 32 of the present disclosure is disposed in the mobile device 3, and displays a processing result.

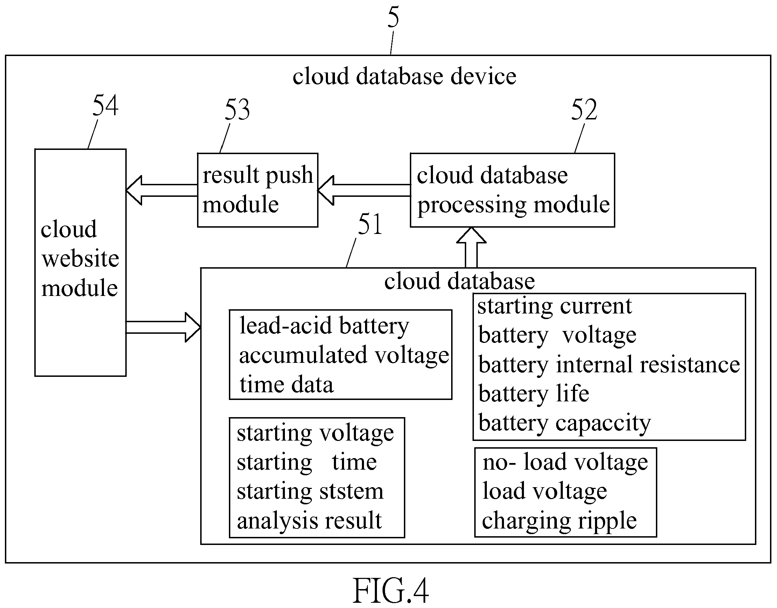

In the preferred embodiment of the present disclosure, as shown in Figs. 1 and 4, the battery detection system of the present disclosure may further include a cloud database device 5. The cloud database device 5 may include a cloud database 51, a cloud database processing module 52, and result push module 53 and a cloud website module 54. The cloud database 51 may stores the data from the mobile device 3. The cloud database processing module 52 may automatically extract and calculate/analyze the data in the cloud database 51, and send an operation result or historical test data to the cloud website module 54 through the result push module 53.

In the preferred embodiment of the present disclosure, referring to Fig. 3, the mobile device 3 of the present disclosure may include a mobile storage module 33, and wireless login module 34 and a cloud database login module 35. The mobile storage module 33 stores a plurality of user test history data. The wireless login module 34 may include a user name 341 and a wireless device name 342. In addition, the wireless login module 34 is connected to the wireless transmission module 13 by the wireless transmission 2 to read the data of the battery 6. The wireless transmission 2 may be 3G, 4G, wireless network, RFID, Bluetooth or the combination thereof. It should be noted that the best wireless transmission 2 is a Blue transmission. Moreover, the cloud database login module 35 may include a username 351 and a PIN code 352. The cloud login module 35 is connected to the cloud website module 54 (as shown in Figs. 1 and 3) by the Internet transmission 4 to read the operation result and the historical test data.

In the preferred embodiment of the present disclosure, as shown in Fig. 3, the mobile processing module 31 may perform battery monitoring 311, battery testing 312, startup system testing 313 and charging system testing 314 on the battery 6.

It is worth mentioning that the above data may include a battery voltage, a battery internal resistance and a starting current. Additionally, the above battery 6 may be one of a lead-acid battery and a lithium battery. The above wireless transmission module 13 may be one of a 3G module, a 4G module, a wireless network module, an RFID module and a Bluetooth transmission module. It is also worth noting that the best wireless transmission module 13 is a Bluetooth transmission module.

According to a first example of the present disclosure, as shown in Figs. 1-4, when the mobile processing module 31 in the mobile device 3 performs battery monitoring 311 on the battery 6, the battery testing device 1 automatically collects battery voltage data according to the set time and stores it in the memory module 12 of the battery testing device 1 (for example, 255 records). When the mobile device 3 instructs to retrieve the transmission data, the stored data is cleared after the transmission is completed and the battery voltage data is recorded; meanwhile, the mobile device 3 reads the data of the memory module 12 of the battery testing device 1 and the voltage graph is continuously drawn, so as to achieve long-term monitoring of voltage status and long-term analysis of battery status, so that users have more specific information to understand the battery usage. The problems can be solved by communicating with the vendors based on the data. The obtained battery voltage data is uploaded to the cloud database device 5 and the analysis result of the cloud database device 5 is received. That is to say, the cloud database device 5 receives the battery voltage data transmitted by the mobile device 3 and analyzes and predicts the battery status and the battery life by means of algorithm. The result of analysis and prediction can be pushed to the mobile device 3 and displayed on the mobile device 3.

According to a second example of the present disclosure, when the mobile processing module 31 in the mobile device 3 performs battery testing 312 on the battery 6, the battery testing device 1 receives the instruction from the mobile device 3 and the battery testing device 1 will perform the test on the battery 6. Data such as battery voltage, starting current and internal resistance of the battery is obtained and is transmitted to the mobile device 3; subsequently, the mobile device 3 reads the transmitted battery voltage, starting current, battery internal resistance, etc, and calculates the battery capacity, the battery life and the battery status. The results are then displayed. Finally, the data of tested battery voltage, battery capacity, batter life, battery internal resistance and starting current are uploaded to the cloud database device 5. The cloud database device 5 receives the above data. The data are analyzed by algorithm to predict the battery status and the battery life. The results are pushed to the mobile device 3 and displayed on the mobile device 3.

According to a third example of the present disclosure, when the mobile processing module 31 in the mobile device 3 performs startup system testing 313 on the battery 6, the battery testing device 1 continues to wait until the battery voltage drops 0.5V and starts to automatically record the battery voltage data, and the battery voltage minimum point and the battery voltage recovery time point will be calculated simultaneously. The accumulated battery voltage data will be transmitted to the mobile device 3. Subsequently, the mobile device 3 will read the transmitted data of the minimum point of the battery voltage, the startup time and the battery voltage accumulation data. The battery startup status will be calculated and the test result page will be displayed. After that, the minimum point of the battery voltage and the startup time will be uploaded to the cloud database device 5. Finally, the cloud database device 5 receives the minimum point of the battery voltage and the startup time transmitted by the mobile 3 and analyzes and predicts the battery status and the battery life by means of algorithm. The result of analysis and prediction can be pushed to the mobile device 3 and displayed on the mobile device 3.

According to a fourth example of the present disclosure, when the mobile processing module 31 in the mobile device 3 performs charging system testing 314 on the battery 6, the battery testing device 1 receives the instruction from the mobile device 3, continues to perform battery voltage testing, and transmits data to the mobile device 3. The mobile device 3 will read the transmitted battery voltage, and will calculate the power generator load voltage, the power generator no-load voltage and the power generator ripple. The power generator system status will be calculated and the test result will be displayed. After that, the data of the power generator load voltage, the power generator no-load voltage and the power generator ripple are uploaded to the cloud database device 5. Finally, the cloud database device 5 receives the data of the power generator load voltage, the power generator no-load voltage and the power generator ripple transmitted by the mobile device 3. The data are analyzed by algorithm to predict the battery status and the battery life. The results are pushed to the mobile device 3 and displayed on the mobile device 3.

According to the above examples of the present disclosure, the mobile device 3 described above may be called a handheld device, a mobile terminal, a mobile communication terminal, etc. and includes a mobile, a smartphone, a notebook, a tablet computer, a vehicle-mounted computer and the like.

In summary, according to the battery detection system provided by the present disclosure, the present disclosure has the following advantages: 1. reducing the production cost of the battery testing device (due to the popularization and wireless transmission technology of the smartphone in recent years, the LCD display and the single-chip processor originally disposed on a testing device can be disposed on a mobile device, for example, a smarphone, accordingly, the production cost, product size and weight of the testing device can be effectively reduced); 2. realizing an on-vehicle miniaturized battery testing device (the battery testing device can monitor changes in battery voltage over a long period of time and enable consumers to more effectively understand the use of vehicle batteries, for example, consumers can determine whether the vehicle battery is undercharged for a long period of time, or the vehicle battery may be overcharged, resulting in damage to the vehicle battery, such that consumer have more definite data to talk with the manufacturer); 3. simple and clear battery test (consumers can perform voltage testing, CCA, internal resistance, SOC and SOH on a battery at any time by means of a mobile device, so as to better understand the battery current status); 4. simple vehicle startup and power generator testing (consumers can test the startup capability of vehicle batteries at any time through a mobile devices, the risk of vehicle batteries suddenly failing to start can be reduced); 5. recording various test data (consumers can understand the usage status and the battery manufacturer and the distribution company have more specific data to analyze the situation); 6. Establishment of cloud database devices (various test data such as voltage, CCA, internal resistance, SOC, SOH, startup voltage, startup time, charging voltage, etc. can be accurately analyzed by a mobile device to predict the battery life, the time of damage and push messages. The battery life, the time of damage and push messages can be pushed to users via the Internet, so that users can understand the situation of the battery at the first time and avoid subsequent troubles.)

Although the present disclosure has been described with reference to the preferred exemplary preferred embodiments thereof, it is apparent to those skilled in the art that a variety of modifications and changes may be made without departing from the scope of the present disclosure which is intended to be defined by the appended claims.

## Claims

1. A battery detection system, comprising:
a battery testing device, including a test processor, a memory module and a wireless transmission module, wherein the test processor tests a battery and collects data of the battery, and stores the data in the memory module;
a mobile processing module, disposed in a mobile device, and processes the data from the battery testing device through the wireless transmission module;
a mobile display module, disposed in the mobile device, and displays a processing result; and
a cloud database device, including a cloud database, a cloud database processing module, a result push module and a cloud website module, wherein the cloud database stores the data from the mobile device, the cloud database processing module automatically extracts and calculates/analyzes the data in the cloud database, and sends an operation result or historical test data to the cloud website module through the result push module.

2. The battery detection system of claim 1, wherein the mobile device further includes a module storage module, a wireless login module and a cloud database login module.

3. The battery detection system of claim 2, wherein the mobile storage module stores a plurality of user test history data.

4. The battery detection system of claim 2, wherein the wireless login module includes a username and a wireless device name, wherein the wireless login module is connected to the wireless transmission module by wireless transmission to read the data of the battery.

5. The battery detection system of claim 1 or 2, wherein the cloud database login module includes a username and a PIN code, wherein the cloud database login module is connected to the cloud website module by Internet transmission to read the operation result and the historical test data.

6. The battery detection system of claim 1, wherein the mobile processing module performs battery monitoring, battery testing, startup system testing and charging system testing on the battery.

7. The battery detection system of claim 1, wherein the data includes a battery voltage, a battery internal resistance and a starting current.

8. The battery detection system of claim 1, wherein the battery is one of a lead-acid battery and a lithium battery.

9. The battery detection system of claim 1, wherein the wireless transmission module is one of a 3G module, a 4G module, a wireless network module, an RFID module and a Bluetooth transmission module.
